# EUROPEAN PATENT APPLICATION

(11) **EP 4 632 807 A1**
(43) Date of publication of application: **15.10.2025**
(21) Application number: 24169222.7
(22) Date of filing: 09.04.2024
(51) Int. Cl.: H01L 23/367, H01L 23/373

(54) **HEAT SINK AND COOLED ELECTRICAL ASSEMBLY COMPRISING THE SAME**

(71) Applicant: ABB SCHWEIZ AG, 5400 Baden (CH)
(72) Inventor: Rapinoja, Hanna, 00380 Helsinki (FI); Himmanen, Mikko, 00380 Helsinki (FI); Salmia, Teemu, 00380 Helsinki (FI)
(74) Representative: Kolster Oy Ab

(57) **Abstract**

A heat sink comprising a base plate (2) made of a first material and having a first surface (21) adapted to be in a heat conducting connection with at least one electrical component (100'), and a second surface (22) adapted to transfer heat away from the base plate (2), the second surface (22) facing an opposite direction than the first surface (21). The heat sink comprises at least one cooling insert (4) made of a second material whose thermal conductivity is better than thermal conductivity of the first material. The base plate (2) comprises at least one through hole extending from the first surface (21) to the second surface (22) thereof, and the at least one cooling insert (4) is located in the at least one through hole.

## Description

### FIELD OF THE INVENTION

The present invention relates to a heat sink and to a cooled electrical assembly comprising the heat sink.

### BACKGROUND OF THE INVENTION

A known heat sink is made of aluminium. In some cases, the thermal conductivity of aluminium is not sufficient. In such cases, it is known to use heat sinks made of copper whose thermal conductivity is almost double compared to the thermal conductivity of aluminium. On the other hand, the density of copper is about three times the density of aluminium. In addition, copper is much more expensive than aluminium. Therefore, a heat sink made of copper is heavy and expensive.

Another known heat sink comprises a base plate made of copper and cooling fins made of aluminium. One of the disadvantages associated with such a known heat sink is that in a main heat transfer direction of the heat sink, there is a junction between copper and aluminium, said junction being detrimental for heat transfer capability of the heat sink. Herein, the main heat transfer direction of the heat sink is a direction from a component cooled by the heat sink to outer ends of the cooling fins.

### BRIEF DESCRIPTION OF THE INVENTION

An object of the present invention is to provide a heat sink and a cooled electrical assembly comprising the heat sink so as to alleviate the above disadvantages. The objects of the invention are achieved by a heat sink and a cooled electrical assembly which are characterized by what is stated in the independent claims. The preferred embodiments of the invention are disclosed in the dependent claims.

The invention is based on the idea of providing a heat sink with a base plate made of a first material and at least one cooling insert made of second material whose thermal conductivity is better than thermal conductivity of the first material, wherein the at least one cooling insert is located in at least one through hole provided in the base plate.

An advantage of the heat sink of the invention is that an improved heat transfer capability is achieved while only a portion of the heat sink is made of the second material. Further, in the heat sink of the present invention, no junctions between the first material and the second material are required in the main heat transfer direction of the heat sink, thereby further improving heat transfer capability of the heat sink.

Unlike a heat sink comprising a heat pipe, the heat sink of the present invention can be used in any position.

In many cooled electrical assemblies, a surface area of electrical components in heat conducting contact with the heat sink is much smaller than the total surface area of the heat sink. Therefore, by locating the cooling inserts adjacent to the electrical components, it is possible to significantly improve cooling of the electrical components while keeping amount of the second material small compared to amount of the first material.

### BRIEF DESCRIPTION OF THE DRAWINGS

In the following the invention will be described in greater detail by means of preferred embodiments with reference to the attached drawings, in which
Figure 1 shows a heat sink according to an embodiment of the invention;
Figure 2 shows a cross sectional view of the heat sink shown in Figure 1;
Figure 3 shows a cooling insert of the heat sink shown in Figure 1;
Figure 4 shows a heat sink according to another embodiment of the invention;
Figure 5 shows a cooled electrical assembly according to an embodiment of the invention; and
Figure 6 shows the cooled electrical assembly shown in Figure 5 in a partially disassembled state.

### DETAILED DESCRIPTION OF THE INVENTION

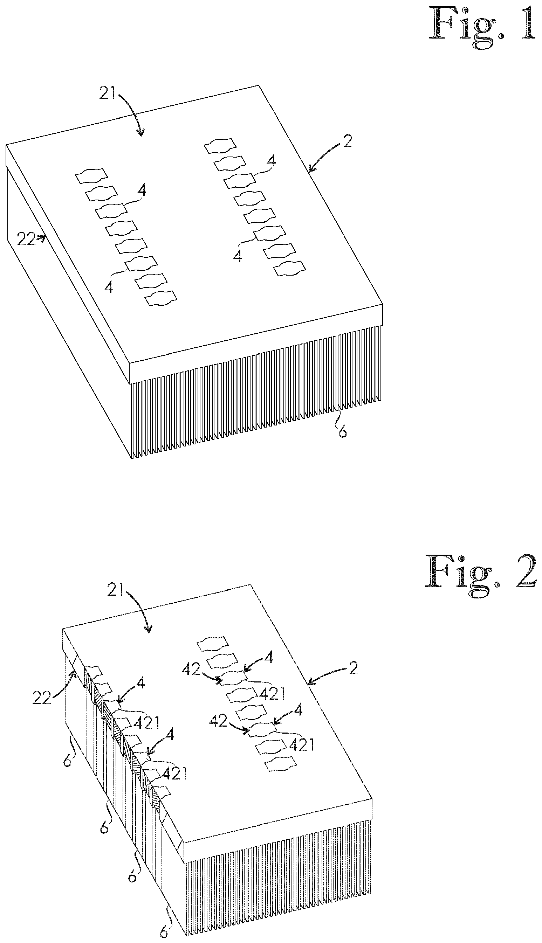

Figure 1 shows a heat sink comprising a base plate 2 and sixteen cooling inserts 4.

The base plate 2 is made of a first material and has a first surface 21 adapted to be in heat conducting connection with at least one electrical component requiring cooling, and a second surface 22 adapted to transfer heat away from the base plate 2. The second surface 22 of the base plate 2 faces an opposite direction than the first surface 21 of the base plate 2. The first surface 21 and the second surface 22 of the base plate 2 are both planar surfaces parallel with each other.

In an embodiment, a thickness of the base plate is greater than or equal to 5mm, wherein the thickness is a dimension perpendicular to the first surface of the base plate.

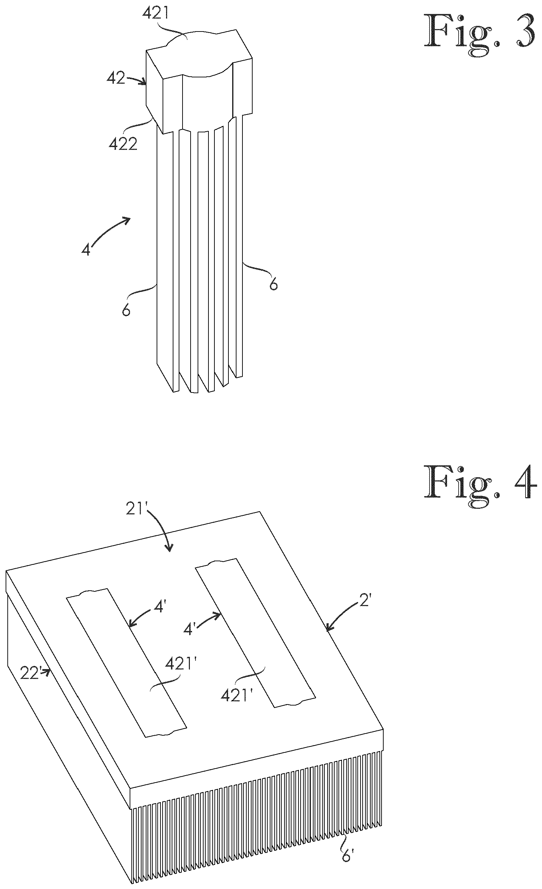

Figure 2 shows a cross sectional view of the heat sink shown in Figure 1. The cross section of Figure 2 is taken along a plane perpendicular to a plane defined by the first surface 21 of the base plate 2. Figure 3 shows one of the cooling inserts 4 of the heat sink shown in Figure 1 as a separate component.

Each of the cooling inserts 4 is made of second material whose thermal conductivity is better than thermal conductivity of the first material. Each cooling insert 4 is provided with a body part 42 having a first surface 421 and a second surface 422 facing an opposite direction than the first surface 421. The cooling inserts 4 are identical with each other.

The base plate 2 comprises sixteen through holes, one for each of the cooling inserts 4. Each of the through holes extends from the first surface 21 of the base plate 2 to the second surface 22 of the base plate 2. The through holes are identical with each other. Each cooling insert 4 is located in a corresponding through hole such that a plane defined by the first surface 421 of the cooling insert 4 coincides with the plane defined by the first surface 21 of the base plate 2. Further, a plane defined by the second surface 422 of the cooling insert 4 coincides with a plane defined by the second surface 22 of the base plate 2. There is a good heat transferring contact between each cooling insert 4 and the base plate 2.

The sixteen cooling inserts 4 are arranged in two cooling insert rows each having eight cooling inserts 4. The cooling insert rows are parallel with each other.

In an embodiment, on the plane defined by the first surface of the base plate, a projection of the heat sink has a surface area greater than or equal to 10cm².

The heat sink shown in Figure 1 comprises a plurality of cooling fins 6 for improving heat transfer of the heat sink. The plurality of cooling fins 6 comprises cooling fins extending from the second surface 22 of the base plate 2 and cooling fins extending from the second surfaces 422 of cooling inserts 4. Referring to Figure 3, each cooling insert 4 comprises five parallel cooling fins 6.

Lengths of cooling fins extending from the second surface 22 of the base plate 2 are equal to lengths of cooling fins extending from the second surfaces 422 of cooling inserts 4. The length of the cooling fins is perpendicular to the plane defined by the first surface 21 of the base plate 2. In an embodiment, a length of each of the cooling fins is greater than or equal to 10mm.

In an alternative embodiment, the heat sink does not comprise any cooling fins.

Each of the through holes in the base plate 2 has a non-circular cross-section. Each through hole comprises a circular centre opening and two recesses extending from opposite sides of the centre opening. The body part 42 of each of the cooling inserts 4 has a non-circular cross-section. The body part 42 comprises a base having a circular cross section, and two projections extending from opposite sides of the base. The geometry of the body part 42 of the cooling insert 4 corresponds to the geometry of the through hole in the base plate 2 such that the body part 42 in practice fulfils the through hole.

The non-circular cross-sections of the through holes and the body parts 42 of the cooling inserts 4 are adapted to co-operate for aligning the cooling fins of the cooling inserts 4 with the cooling fins of the base plate 2. Both the cooling fins of the cooling inserts 4 and the cooling fins of the base plate 2 are planar cooling fins, wherein said alignment ensures that all the cooling fins of the heat sink have identical direction.

As best seen in Figure 2, the direction of the cooling fins is parallel with the direction of the cooling insert rows. The heat sink comprises ten cooling fin units each of which consists of eight cooling fins of cooling inserts 4 and nine cooling fins of the base plate 2 such that adjacent cooling fins of the cooling fin unit abut each other. The rest of cooling fin units of the heat sink are monolithic or unbroken units each consisting of exactly one cooling fin of the base plate 2.

Cross-sections of the body parts 42 of the cooling inserts 4 are small compared to the base plate 2. In an embodiment, on a plane parallel with the plane defined by the first surface of the base plate, a cross-section of the body part of the cooling insert has a surface area greater than or equal to 25mm².

A ratio between a surface area of the first surface 421 of an individual cooling insert 4 and a surface area of a total receiving surface of the heat sink is smaller than 0.5%. Therefore, a ratio between a combined surface area of the first surfaces 421 of the cooling inserts 4 and the surface area of the total receiving surface of the heat sink is smaller than 10%. The total receiving surface of the heat sink is a sum of the first surface 21 of the base plate 2 and the first surfaces 421 of the cooling inserts 4.

In an alternative embodiment, a ratio between a surface area of the first surface of an individual cooling insert and a surface area of a total receiving surface of the heat sink is smaller than or equal to 5%. In a further alternative embodiment, a ratio between a combined surface area of the first surfaces of the cooling inserts and the surface area of the total receiving surface of the heat sink is smaller than or equal to 50%.

Each of the cooling inserts 4 is joined to the base plate 2 with at least one welded joint formed on the first surfaces of the base plate 2 and the cooling insert 4. In other words, welded joints connecting the cooling inserts 4 to the base plate 2 are realized from that side of the base plate 2 where the first surface 21 is. Since the welding process is carried out on the first surfaces of the base plate 2 and the cooling inserts 4, the cooling fins 6 do not interfere with the welding and the length of the cooling fins has no effect on the welding.

In an embodiment, the at least one welded joint between the base plate and the at least one cooling insert is realized by friction welding or laser welding. In another embodiment, the first surfaces of the base plate and the at least one cooling insert are machined to desired quality after the welding process.

In an alternative embodiment, there is an interference fit or press fit between at least one cooling insert and the base plate. In a further alternative embodiment, a welded joint is used together with an interference fit. The tighter the fit between the cooling insert and the base plate, the better heat is transferred between the cooling insert and the base plate.

In an embodiment, the first material is an aluminium material comprising at least 75% aluminium by weight, and the second material is a copper material comprising at least 90% copper by weight.

Figure 4 shows a heat sink according to another embodiment of the invention, the heat sink comprising a base plate 2' and two cooling inserts 4'. A cross section of each of the cooling inserts 4' has substantially a form of a rectangle. Except for the number, size and design of the cooling inserts 4', the heat sink of Figure 4 is identical with the heat sink of Figure 1.

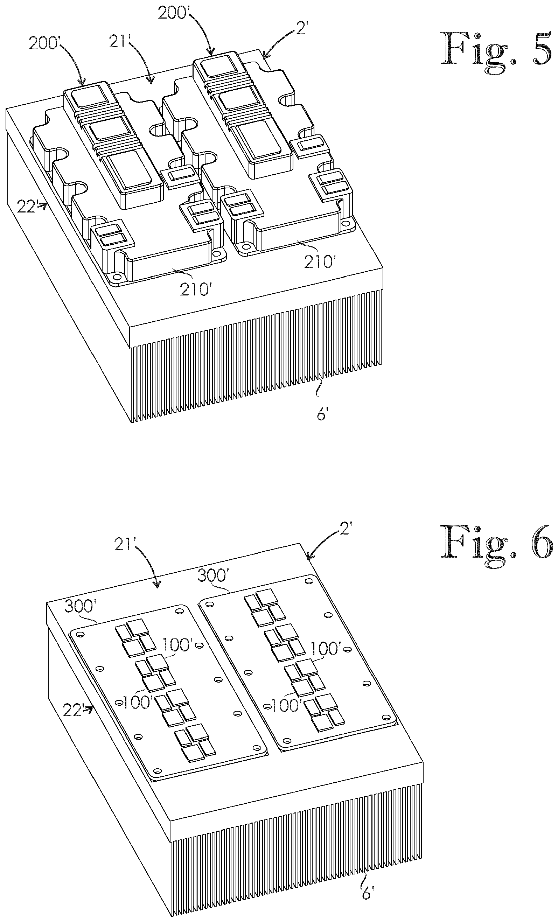

Figure 5 shows a cooled electrical assembly comprising the heat sink shown in Figure 4 and a plurality of electrical components in heat conducting connection with the heat sink. Figure 6 shows the cooled electrical assembly shown in Figure 5 in a partially disassembled state.

The cooled electrical assembly of Figure 5 comprises two IGBT modules 200' placed on the first surface 21' of the base plate 2'. Referring to Figure 6, each of the IGBT modules 200' comprises a mounting board 300' and sixteen electrical components 100' placed on the mounting board 300'.

In Figure 6, casings 210' of the IGBT modules 200', along with some auxiliary components relating to controlling the electrical components 100' and electrically connecting the electrical components 100' to other parts of the IGBT modules 200' have been omitted.

The mounting board 300' is made of material having high thermal conductivity. The mounting board 300' is in heat conducting contact with the first surface 21' of the base plate 2' and first surfaces 421' of the cooling inserts 4'. The electrical components 100' are in heat conducting connection with the heat sink through the mounting board 300'.

A ratio between a surface area of the first surfaces 421' of the two cooling inserts 4' and a surface area of the sixteen electrical components 100' in heat conducting connection with the heat sink is greater than 100%. On a plane parallel with the plane defined by the first surface 21' of the base plate 2', projections of the electrical components 100' are within projections of the cooling inserts 4'. In an alternative embodiment, on a plane parallel with the plane defined by the first surface of the base plate, a projection of the at least one electrical component overlaps with a projection of the at least one cooling insert.

In an embodiment, at least one electrical component in heat conducting connection with the heat sink comprises a semiconductor switch whose nominal power is greater than or equal to 10W. In another embodiment, a load of the at least one electrical component in heat conducting connection with the heat sink is a cyclic load.

It will be obvious to a person skilled in the art that the inventive concept can be implemented in various ways. The invention and its embodiments are not limited to the examples described above but may vary within the scope of the claims.

## Claims

1. A heat sink comprising:
a base plate (2) made of a first material and having a first surface (21) adapted to be in a heat conducting connection with at least one electrical component (100'), and a second surface (22) adapted to transfer heat away from the base plate (2), the second surface (22) facing an opposite direction than the first surface (21),
**characterized in that** the heat sink comprises at least one cooling insert (4) made of a second material whose thermal conductivity is better than thermal conductivity of the first material, wherein the at least one cooling insert (4) is provided with a body part (42) having a first surface (421) and a second surface (422) facing an opposite direction than the first surface (421),
wherein the base plate (2) comprises at least one through hole extending from the first surface (21) to the second surface (22) thereof, and the at least one cooling insert (4) is located in the at least one through hole such that a plane defined by the first surface (421) of the at least one cooling insert (4) coincides with a plane defined by the first surface (21) of the base plate (2).

2. The heat sink according to claim 1, wherein the heat sink comprises at least one cooling fin (6) for improving heat transfer from the first surface (21) to the second surface (22), wherein the at least one cooling fin (6) comprises at least one cooling fin extending from the second surface (22) of the base plate (2) and/or at least one cooling fin extending from the second surface (422) of the at least one cooling insert (4).

3. The heat sink according to claim 2, wherein the at least one cooling fin (6) comprises at least one cooling fin extending from the second surface (422) of the at least one cooling insert (4), and a length of the at least one cooling fin (6) is greater than or equal to 10mm.

4. The heat sink according to claim 2 or 3, wherein both the base plate (2) and the at least one cooling insert (4) are provided with at least one cooling fin (6), and both the at least one through hole and the body part (42) of the at least one cooling insert (4) have a non-circular cross-section adapted to co-operate for aligning the at least one cooling fin of the at least one cooling insert (4) with the at least one cooling fin of the base plate (2).

5. The heat sink according to claim 4, wherein both the at least one cooling fin of the at least one cooling insert (4) and the at least one cooling fin of the base plate (2) are planar cooling fins.

6. The heat sink according to any one of the preceding claims, wherein a thickness of the base plate (2) is greater than or equal to 5mm.

7. The heat sink according to any one of the preceding claims, wherein on a plane parallel with the plane defined by the first surface (21) of the base plate (2), a cross-section of the body part of an individual cooling insert (4) has a surface area greater than or equal to 25mm².

8. The heat sink according to any one of the preceding claims, wherein a ratio between a surface area of the first surface (421) of an individual cooling insert (4) and a surface area of a total receiving surface of the heat sink is smaller than or equal to 5%, wherein the total receiving surface is a sum of the first surface (21) of the base plate (2) and the first surface (421) of the at least one cooling insert (4).

9. The heat sink according to any one of the preceding claims, wherein the at least one cooling insert (4) is joined to the base plate (2) with at least one welded joint formed on the first surfaces of the base plate (2) and the at least one cooling insert (4).

10. The heat sink according to any one of the preceding claims, wherein the first material is an aluminium material comprising at least 75% aluminium by weight, and the second material is a copper material comprising at least 90% copper by weight.

11. A cooled electrical assembly comprising the heat sink according to any one of the preceding claims, and at least one electrical component (100') in heat conducting connection with the first surface (421') of the at least one cooling insert (4').

12. The cooled electrical assembly according to claim 11, wherein a ratio between a surface area of the first surface (421') of the at least one cooling insert (4') and a surface area of the at least one electrical component (100') in heat conducting connection with the first surface (421') of the at least one cooling insert (4') is greater than or equal to 100%.

13. The cooled electrical assembly according to claim 11 or 12, wherein on a plane parallel with the plane defined by the first surface of the base plate (2'), a projection of the at least one electrical component (100') at least overlaps with a projection of the at least one cooling insert (4').

14. The cooled electrical assembly according to any one of claims 11-13, wherein each of the at least one electrical component (100') comprises a semiconductor switch whose nominal power is greater than or equal to 10W.
